# EUROPÄISCHE PATENTSCHRIFT

(11) **EP 1 305 644 B1**
(45) Veröffentlichungstag und Bekanntmachung des Hinweises auf die Patenterteilung: **05.01.2005**
(21) Anmeldenummer: 01969341.5
(22) Anmeldetag: 05.07.2001
(51) Int. Cl.: G01R 23/16, H04B 17/00

(54) **VERFAHREN UND MESSVORRICHTUNG ZUR MESSUNG DES SPEKTRUMS IN NACHBARKANÄLEN**
METHOD AND MEASURING DEVICE FOR MEASURING THE SPECTRA IN ADJACENT CHANNELS
PROCEDE ET DISPOSITIF DE MESURE DU SPECTRE DANS DES CANAUX ADJACENTS

(30) Priorität: 28.07.2000 DE 10036877; 06.09.2000 DE 10043894
(43) Veröffentlichungstag der Anmeldung: 02.05.2003
(73) Patentinhaber: Rohde & Schwarz GmbH & Co. KG, 81671 München (DE)
(72) Erfinder: OETJEN, Martin, 82194 Gröbenzell (DE); LORENZEN, Rolf, 82008 Unterhaching (DE); FIECHTNER, Falko, 87700 Memmingen (DE)
(74) Vertreter: Körfer, Thomas, Dipl.-Phys.
(86) Internationale Anmeldenummer: PCT/EP2001/007723
(87) Internationale Veröffentlichungsnummer: WO 2002/011295

(56) Entgegenhaltungen:
- EP-A- 0 081 172
- WO-A-96/22540
- US-A- 5 706 202
- PATENT ABSTRACTS OF JAPAN vol. 1999, no. 12, 29. Oktober 1999 (1999-10-29) & JP 11 194145 A (ADVANTEST CORP), 21. Juli 1999 (1999-07-21)

## Beschreibung

Die Erfindung betrifft ein Verfahren zur Messung des Spektrums eines Meßsignals in mehreren einem Nutzkanal benachbarten Nachbarkanälen und eine entsprechende Meßvorrichtung.

In dem Standard ETSI Specs GSM 11.21 wird definiert, welchen Signalpegel Nebenaussendungen in den einem Nutzkanal benachbarten Nachbarkanälen maximal erreichen dürfen. Um zu prüfen, ob Mobilfunkstationen oder Basisstationen diesen Standard erfüllen, dient das erfindungsgemäße Meßverfahren und die erfindungsgemäße Meßvorrichtung. Das erfindungsgemäße Meßverfahren und die erfindungsgemäße Meßvorrichtung eignen sich jedoch grundsätzlich auch zur Messung von Nebenaussendungen in Nachbarkanälen von Signalen, insbesondere Mobilfunksignalen nach anderen Standards, insbesondere dem EDGE-Standard oder dem UMTS-Standard.

Die Spezifikation nach ETSI-Specs GSM 11,21 fordert sowohl eine Überprüfung des Spektrums, das durch die Modulation verursacht wird (due to modulation) als auch des Spektrums, das durch das Ein- und Ausschalten der Bursts verursacht wird (due to switching). Das GSM-Signal gliedert sich bekanntlich in mehrere Frames mit einer Framedauer von ca. 4,7ms. Die vorstehend genannte Vorschrift fordert bei der Messung des Spektrums aufgrund der Modulation (due to modulation) das Ausmessen von 21 Kanälen (den Nutzkanal und Nachbarkanäle oberhalb und unterhalb des Nutzkanals) über zumindest 200 Frames, über welche anschließend gemittelt wird. Werden die Messungen für jeden Kanal separat durchgeführt, so müssen insgesamt 21·200 Messungen mit einer Meßdauer von mindestens 4,7ms durchgeführt werden, so daß die theoretische Mindestmeßdauer ca. 20 Sekunden beträgt. Bei einer automatischen Vermessung von Mobilstationen oder Basisstationen beispielsweise am Ende einer Fertigung ist diese Meßdauer relativ lang, zumal auch noch weitere Messungen anderer Spezifikationen durchgeführt werden müssen. Diese Meßdauer kann daher den Fertigungsablauf beeinträchtigen.

Zusätzlich muß eine Messung des Spektrums aufgrund des Einund Ausschaltens der Bursts (due to switching) durchgeführt werden. Die vorstehend genannte Spezifikation erfordert hier eine Messung von 9 Kanälen (den Nutzkanal und Nachbarkanäle oberhalb und unterhalb des Nutzkanals) über mindestens 20 Frames.

US 5 706 202 (Itahara et al.), Jan. 6, 1998 offenbart ein Verfahren zur Messung des Spektrums eines Meßsignals mit parallellen, breitbandigem Erfassen des Meßsignals.

Der Erfindung liegt deshalb die Aufgabe zugrunde, ein Verfahren zur Messung des Spektrums eines Meßsignals in mehreren einem Nutzkanal benachbarten Nachbarkanälen und eine entsprechende Meßvorrichtung zu schaffen, bei welchem bzw. bei welcher die Gesamtmeßdauer deutlich verringert ist.

Die Aufgabe wird bezüglich des Verfahrens durch die Merkmale des Anspruchs 1 und bezüglich der Meßvorrichtung durch die Merkmale des Anspruchs 7 gelöst. Die Unteransprüche betreffen vorteilhafte Weiterbildungen der Erfindung.

Der Erfindung liegt zunächst die Erkenntnis zugrunde, daß die Meßzeit dadurch signifikant verkürzt werden kann, daß die einzelnen Meßkanäle nicht seriell sondern parallel gemessen werden. Dazu ist es erforderlich, das Meßsignal breitbandig zu erfassen und nicht bereits vor dem Analog/Digital-Wandler auf die Meßbandbreite des jeweiligen Kanals (z. B. 30kHz für den Nachbarkanal und 300kHz für den Nutzkanal) zu beschränken, sondern das Meßsignal breitbandig dem Analog/Digital-Wandler zuzuführen. Es zeigt sich jedoch, daß eine parallele Erfassung des Meßsignals nicht ohne eine weitere erfindungsgemäße Maßnahme möglich ist, da die Signalstärke in den Nachbarkanälen, insbesondere in von dem Nutzkanal relativ weit entfernten Nachbarkanälen ca. 65dB niedriger ist als in dem Nutzkanal. Da der Analog/Digital-Wandler nur eine begrenzte Auflösung hat und andererseit durch die hohe Signalstärke an den Nutzkanal nicht übersteuert werden darf, stellt sich das Problem, wie diesen hohen Dynamikanforderungen begegnet werden kann. Erfindungsgemäß wird deshalb vorgeschlagen, vor dem Analog/Digital-Wandler ein selektives Filter anzuordnen, das das Meßsignal in dem Nutzkanal wesentlich stärker dämpft als in den Nachbarkanälen. Dadurch wird eine Übersteuerung des Analog/Digital-Wandlers in dem Nutzkanal vermieden und das Meßsignal erreicht den Analog/Digital-Wandler in den Nachbarkanälen mit einem höheren Signalpegel. Dadurch kann das Signal auch in den Nachbarkanälen relativ gut quantisiert werden. Dem Analog/Digital-Wandler ist ein Entzerrer nachgeschaltet, dessen Frequenzgang reziprok zu dem Frequenzgang des selektiven Filters ist. Der Einfluß des selektiven Filters auf das Meßsignal wird somit vor der Auswertung kompensiert.

Vorteilhafterweise dämpft das selektive Filter das Meßsignal in den Nachbarkanälen mit zunehmendem Abstand von dem Nutzsignal zunehmend schwächer, so daß jedenfalls das Signal von den nächstgelegenen Nachbarkanälen noch stärker gedämpft wird als das Signal von den weiter abgelegenen Nachbarkanälen. Hierdurch kann die Aussteuerung des Analog/Digital-Wandlers weiter verbessert werden.

Bei der Messung des Spektrums des Nutzkanals ist es vorteilhaft, das selektive Filter abzuschalten. Da das Signal des Nutzsignals ohnehin das dominierende Signal ist, hat das selektive Filter bei der Messung des Nutzkanals keinerlei Vorteile, jedoch den Nachteil, daß aufgrund der mangelnden Konstanz des Frequenzgangs innerhalb der 300 kHz breiten Meßbandbreite in dem Nutzkanal, also im Scheitelpunkt der Filterkennlinie, das Meßsignal verfälscht wird.

Dem Analog/Digital-Wandler ist vorzugsweise ein variabler Verstärker bzw. ein variables Dämpfungselement vorgeschaltet, dessen Verstärkungsfaktor bzw.

Dämpfungsfaktor so eingestellt wird, daß der Aussteuerbereich des Analog/Digital-Wandlers ohne Übersteuerung zumindest nahezu vollständig ausgenutzt wird.

Das Bandpaßfilter, das die Bandweite auf die Meßbandbreite, also beispielsweise auf 30 kHz für die Nachbarkanäle und 300 kHz für den Nutzkanal reduziert, befindet sich vorzugsweise dem Analog/Digital-Wandler. Der Entzerrer und das Bandpaßfilter befinden sich vorzugsweise in einem digitalen Signalprozessor, der auch weitere Signalverarbeitungselemente enthalten kann.

Ein Ausführungsbeispiel der Erfindung wird nachfolgend unter Bezugnahme auf die Zeichnung näher beschrieben. In der Zeichnung zeigen:
- Fig. 1: eine Meßvorrichtung nach dem Stand der Technik,
- Fig. 2: ein Ausführungsbeispiel einer erfindungsgemäßen Meßvorrichtung und
- Fig. 3: ein Beispiel eines Spektrums des Meßsignals und des Frequenzgangs des selektiven Filters.

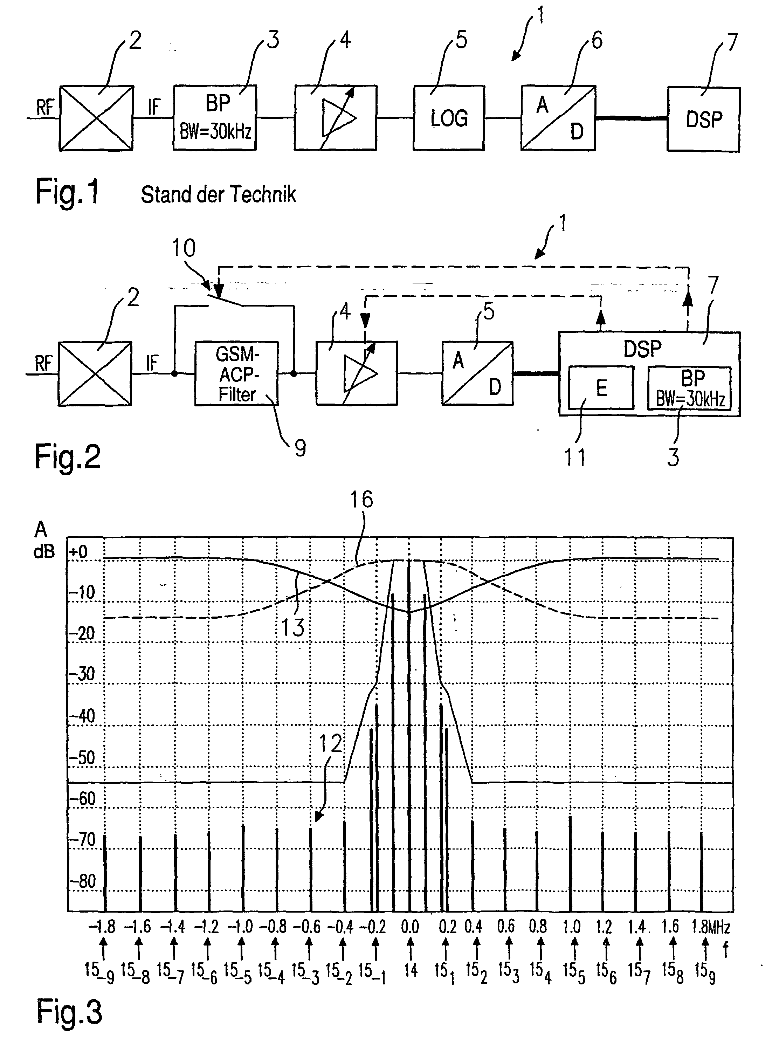

Fig. 1 zeigt ein Beispiel einer Meßvorrichtung 1 nach dem Stand der Technik.

Das hochfrequente Meßsignal RF wird in einer Misch- und Zwischenfrequenzstufe 2 auf die Zwischenfrequenz IF abgesenkt und dann einem Bandpaßfilter 3 zugeführt. Das Bandpaßfilter 3 begrenzt die Meßbandbreite BW in den nacheinander zu vermessenden Nachbarkanälen auf jeweils 30 kHz. Gleichzeitig wird durch das Bandpaßfilter der Signalpegel des Nutzkanals unterdrückt. Dieses gefilterte Signal wird einem variablen Verstärker 4 zugeführt, dessen Verstärkungsfaktor einstellbar ist. Nach dem variablen Verstärker 4 befindet sich ein Element 5 mit nichtlinearer, beispielsweise logarithmischer Kennlinie, um den Aussteuerbereich des nachgeschalteten Analog/Digital-Wandlers 6 in dem Sinne möglichst gleichmäßig zu nutzen, daß die Quantisierungsstufen für Signale mit kleinem Pegel klein und für Signale mit hohem Pegel groß sind. Das Digitalsignal am Ausgang des Analog/Digital-Wandlers 6 wird einem digitalen Signal-Prozessor 7 zugeführt.

Wie bereits beschrieben, ist bei dieser Anordnung nachteilig, daß die Spektren in sämtlichen 21 Kanälen bei der Messung "due to modulation" bzw. in allen 9 Kanälen bei der Messung "due to switching" seriell ausgeführt werden müssen, was zu einer unerwünscht hohen Gesamtmeßzeit führt. Da jedoch jeweils nur ein Meßkanal ausgemessen wird, kann der Verstärkungsfaktor des variablen Verstärkers 4 so angepaßt werden, daß der Analog/Digital-Wandler 6 jeweils zumindest nahezu voll ausgesteuert ist. Der hohe Signalpegel in dem Nutzkanal wird dabei bei der Messung der Nachbarkanäle durch das Bandpaßfilter 3 unterdrückt, so daß keine Übersteuerung des Analog/Digital-Wandlers 6 auftritt. Ein Dynamik-Problem in dem Sinne, daß gleichzeitig Signale mit hohem und mit niedrigem Pegel bei guter Auflösung des Signals mit niedrigem Pegel gemessen werden muß, tritt bei dieser Anordnung nicht auf. Aufgrund dieses Vorzugs wurde bislang an der seriellen Messung festgehalten.

Fig. 2 zeigt ein Ausführungsbeispiel der erfindungsgemäßen Meßvorrichtung, wobei mit Fig. 1 übereinstimmende Elemente mit übereinstimmenden Bezugszeichen versehen wurden.

Abweichend von der in Fig. 1 dargestellten Meßvorrichtung 1 nach dem Stand der Technik wird bei dem in Fig. 2 dargestellten Ausführungsbeispiel der Erfindung die Zwischenfrequenz IF des Meßsignals einem selektiven Filter 9 zugeführt, das in Fig. 2 als GSM-ACP-Filter bezeichnet ist, wobei ACP für adjacent channel power steht. Das selektive Filter 9 ist im dargestellten bevorzugten Ausführungsbeispiel durch einen Schalter 10 überbrückbar, der beispielsweise durch den digitalen Signalprozessor 7 betätigbar ist. Dem selektiven Filter 9 ist der Verstärker 4 mit einstellbarem Verstärkungsfaktor nachgeschaltet, dessen Verstärkungsfaktor ebenfalls durch den digitalen Signal-Prozessor 7 veränderbar ist. Auf den Verstärker 4 folgt der Analog/Digital-Wandler 5, der das Meßsignal in ein Digitalsignal umsetzt, das dem digitalen Signal-Prozessor 7 zugeführt wird. In dem digitalen Signal-Prozessor 7 befindet sich ein Entzerrer 11. Der Frequenzgang des Entzerrers 11 ist so ausgelegt, daß er den Frequenzgang des selektiven Filters 9 reziprok ist, so daß sich die Wirkung des selektiven Filters 9 und des Entzerrers 11 gegenseitig kompensieren. Ferner ist das Bandpaßfilter 3, das eine Begrenzung der Bandbreite auf den zu messenden Kanal vornimmt, ebenfalls Bestandteil des digitalen Signal-Prozessors. Der Entzerrer 11 und das Bandpaßfilter 3 können mit üblichen Mitteln der digitalen Filterung sowohl in Hardware als auch in Software realisiert werden. Neben dem in Fig. 2 dargestellten Bandpaßfilter mit einer Bandbreite BW von 30 kHz kann ein zweites Bandpaßfilter 3 mit einer Bandbreite von 300 kHz zur Messung des Nutzsignals vorhanden sein.

Fig. 3 veranschaulicht die nach dem Standard ETSI-Specs GSM 11.21 vorgeschriebene Meßstellen in dem Signalspektrum. Der Kanalabstand beträgt 200 kHz. Während bei der Messung des Spektrums aufgrund der Modulation (due to modulation) sowohl die Nachbarkanäle 15₋₉-15₉ als auch der Nutzkanal 14 mit einer Bandbreite von 30kHz vermessen werden, erfolgt bei der Messung des Spektrums aufgrund der Schaltvorgänge (due to switching) die Messung in die Nachbarkanäle 15₋₄-15₄ mit einer Bandbreite von 30 kHz, in dem Nutzkanal 14 jedoch mit einer Bandbreite von 300 kHz. Die bei der Messung zu erwartende Signalstärke an den einzelnen Meßpunkten in dem Spektrum ist mit Balken 12 veranschaulicht. Zu erkennen ist der sehr große Dynamikbereich. Der zu erwartende Signalpegel in abgelegenen Nachbarkanälen 15₋₉-15₋₂, 15₂-15₉ ist um mehr als 65 dB kleiner als der Signalpegel in dem Nutzkanal 14.

Würden die Nachbarkanäle 15₋₉-15₉ ohne das erfindungsgemäße selektive Filter 9 parallel vermessen, so bestände das Problem, daß der mehr als 65 dB höhere Signalpegel des Nutzkanals 14 die Ansteuerung des Analog/Digital-Wandlers 5 begrenzt. Denn würde der Verstärkungsfaktor des Verstärkers 4 so eingestellt, daß der Signalpegel in dem Nutzkanal 14 gerade noch nicht den Analog/Digital-Wandler 5 übersteuert, so wäre das Signal in den entfernt liegenden Nachbarkanälen 15₋₉-15₋₂, 15₂-15₉ um mehr als 65dB schwächer und durch den Analog/Digital-Wandler 5 nicht oder kaum noch auflösbar. Dieses Problem besteht bei dem Meßverfahren nach Fig. 1 aufgrund des nicht nachgeschalteten sondern vorgeschalteten Bandpaßfilters 3 grundsätzlich nicht, da das Bandpaßfilter 3 dort den hohen Signalpegel des Nutzkanals 14 ausreichend unterdrückt.

Das erfindungsgemäße selektive Filter 9 schwächt jedoch das Meßsignal zumindest im Bereich des Nutzkanals 14, vorzugsweise auch noch in den Nachbarbereichen, so weit ab, daß eine ausreichende Aussteuerung des Analog/Digital-Wandlers 5 auch für weit entfernt liegende Nachbarkanäle 15₉, 15₉ ermöglicht wird. Dabei kann der Verstärkungsfaktor des variierbaren Verstärkers 4 soweit erhöht werden, daß eine Übersteuerung des Analog/Digital-Wandlers 5 gerade noch vermieden wird, die Auflösung des Analog/Digital-Wandlers 5 jedoch weitgehend ausgenutzt wird. Im in Fig. 3 dargestellten Ausführungsbeispiel dämpft das selektive Filter 9 das Signal in dem Nutzkanal um ca. 15dB. Somit kann der Signalpegel in den entfernten Nachbarkanälen um ca. 15dB angehoben werden. Der Frequenzgang des selektiven Filters 9 ist in Fig. 3 beispielhaft durch die Kurve 13 veranschaulicht.

Zwar führt das erfindungsgemäße selektive Filter 9 zu einer Verzerrung des Meßsignals. Diese Verzerrung kann jedoch mit dem vorzugsweise in dem digitalen Signal-Prozessor 7 vorgesehenen Entzerrer 11 wieder rückgängig gemacht werden, da der Entzerrer 11 einen zu dem Frequenzgang des selektiven Filters 9 reziproken Frequenzgang hat. Der Frequenzgang des Entzerrers 11 hat bei der Mittelfrequenz beispielsweise die Dämpfung 0 und fällt seitlich davon auf ca. 15 dB ab. Der Frequenzgang des Entzerrers ist in Fig. 3 gestrichelt als Kurve 16 eingezeichnet.

Wie bereits beschrieben, ist bei der Messung "due to switching" eine Messung des Nutzkanals 14 mit einer Bandbreite von 300 kHz notwendig. Wie aus Fig. 3 zu ersehen, ist der Frequenzgang des selektiven Filters 9 von -150 kHz bis +150 kHz nicht ausreichend konstant. Bei der Messung des Nutzkanals 14 ist jedoch das selektive Filter 9 auch nicht erforderlich, da hier das Meßsignal das Signal mit dem höchsten Signalpegel ist und somit andere Signale mit höherem Signalpegel nicht unterdrückt werden müssen. In diesem Fall ist es vorteilhaft, das selektive Filter 9 mit dem Schalter 10 zu überbrücken und in dem digitalen Signal-Prozessor 7 gleichzeitig die Funktion des Entzerrers 11 abzuschalten, um eine Verfälschung der Messung durch das selektive Filter 9 zu vermeiden.

Die Erfindung ist nicht auf das dargestellte Ausführungsbeispiel beschränkt und kann bei einer Vielzahl anderer erfindungsgemäßer schaltungstechnischer Realisierungen gleichermaßen Anwendung finden. Ferner ist das erfindungsgemäße Verfahren nicht auf Meßfahren nach dem GSM-Standard beschränkt, sondern kann auch für andere Signale, insbesondere andere Mobilfunksignale, in gleicher Weise angewandt werden.

## Patentansprüche

1. Verfahren zur Messung des Spektrums eines Meßsignals in mehreren einem Nutzkanal (14) benachbarten Nachbarkanälen (15₋₉-15₉) mit folgenden Verfahrensschritten:
- paralleles, breitbandiges Erfassen des Meßsignals über alle zu messende Kanäle (15₋₉-15₉, 14),
- Filtern des breitbandig erfaßten Meßsignals mit einem selektiven Filter (9), das den Nutzkanal (14) stärker dämpft als die Nachbarkanäle (15₋₉-15₉),
- Wandeln des gefilterten, analogen Meßsignals in ein Digitalsignal und
- Entzerren des Digitalsignals mit einem Entzerrer (11), dessen Frequenzgang reziprok zu dem Frequenzgang des selektiven Filters (9) ist.

2. Verfahren nach Anspruch 1,
**dadurch gekennzeichnet,**
**daß** das selektive Filter (9) das Meßsignal in den Nachbarkanälen (15₋₉-15₉) mit zunehmendem Abstand von dem Nutzkanal (14) zunehmend schwächer dämpft.

3. Verfahren nach Anspruch 1 oder 2,
**dadurch gekennzeichnet,**
**daß** gleichzeitig das Spektrum in dem Nutzkanal (14) gemessen wird.

4. Verfahren nach Anspruch 3,
**dadurch gekennzeichnet,**
**daß** das Digitalsignal in dem Nutzkanal (14) einer breitbandigeren Bandpaßfilterung unterworfen wird als in den Nachbarkanälen (15₋₉-15₉).

5. Verfahren nach Anspruch 3 oder 4,
**dadurch gekennzeichnet,**
**daß** bei der Messung des Spektrums des Nutzkanals (14) das selektive Filter (9) abgeschaltet wird.

6. Verfahren nach einem der Ansprüche 1 bis 5,
**dadurch gekennzeichnet,**
**daß** das Meßsignal ein Mobilfunksignal, insbesondere ein Signal nach dem GSM-, EDGE- oder UTMS-Standard ist.

7. Meßvorrichtung (1) zur Messung des Spektrums eines Meßsignals in mehreren einem Nutzkanal (14) benachbarten Nachbarkanälen (15₋₉-15₉) mit
- einem selektiven Filter (9), das den Nutzkanal (14) stärker dämpft als die Nachbarkanäle (15₋₉-15₉),
- einem Analog/Digital-Wandler, (5), der das gefilterte Meßsignal über alle zu messende Kanäle (15₋₉-15₉) parallel, breitbandig erfaßt und in ein Digitalsignal umwandelt, und
- einem Entzerrer (11), der das Digitalsignal mit einem Frequenzgang reziprok zu dem Frequenzgang des selektiven Filters (9) entzerrt.

8. Meßvorrichtung nach Anspruch 7,
**dadurch gekennzeichnet,**
**daß** das selektive Filter (9) das Meßsignal in den Nachbarkanälen (15₋₉-15₉) mit zunehmendem Abstand von dem Nutzkanal (14) zunehmend schwächer dämpft.

9. Meßvorrichtung nach Anspruch 7 oder 8,
**dadurch gekennzeichnet,**
**daß** dem Analog/Digital-Wandler (5) ein variabler Verstärker (4) oder ein variables Dämpfungselement vorgeschaltet ist, dessen Verstärkungsfaktor bzw. Dämpfungsfaktor so eingestellt ist, daß der Aussteuerbereich des Analog/Digital-Wandlers (5) ohne Übersteuerung zumindest nahezu vollständig ausgenutzt wird.

10. Meßvorrichtung nach einem der Ansprüche 7 bis 9,
**dadurch gekennzeichnet,**
**daß** dem Analog/Digital-Wandler (5) ein digitales Bandpaßfilter (3) nachgeschaltet ist.

11. Meßvorrichtung nach Anspruch 10,
**dadurch gekennzeichnet,**
**daß** neben den Spektren in den Nachbarkanälen (15₋₉-15₉) auch das Spektrum in dem Nutzkanal (14) gemessen wird, und das Bandpaßfilter (3) für den Nutzkanal (14) eine größere Bandbreite hat als für die Nachbarkanäle (15₋₉-15₉) hat.

12. Meßvorrichtung nach Anspruch 10 oder 11,
**dadurch gekennzeichnet,**
**daß** der Entzerrer (11) und das Bandpaßfilter (3) Bestandteil eines digitalen Signal-Prozessors (7) sind.

## Claims

1. A method for measuring the spectrum of a measurement signal in several neighbouring channels (15₋₉ - 15₉) adjacent to a working channel (14) with the following process steps:
- parallel broadband detection of the measurement signal over all channels to be measured (15₋₉ - 15₉, 14),
- filtering of the broadband detected measurement signal with a selective filter (9) which attenuates the working channel (14) more than the adjacent channels (15₋₉ - 15₉),
- conversion of the filtered analog measurement signal into a digital signal, and
- equalisation of the digital signal with an equaliser (11), the frequency response of which is reciprocal to the frequency response of the selective filter (9).

2. A method according to claim 1, **characterised in that** the selective filter (9) attenuates the measurement signal in the neighbouring channels (15₋₉ - 15₉) more weakly as the distance from the working channel (14) increases.

3. A method according to claim 1 or 2, **characterised in that** at the same time the spectrum in the working channel (14) is measured.

4. A method according to claim 3, **characterised in that** the digital signal in the working channel (14) is subjected to a broader band bandpass filtration than in the neighbouring channels (15₋₉ - 15₉).

5. A method according to claim 3 or 4, **characterised in that** in the measurement of the spectrum of the working channel (14) the selective filter (9) is disconnected.

6. A method according to any of claims 1 to 5, **characterised in that** the measurement signal is a mobile phone signal, in particular a signal according to the GSM, EDGE or UTMS standard.

7. A measurement device (1) for measuring the spectrum of a measurement signal in several neighbouring
channels (15₋₉ - 15₉) adjacent to a working
channel (14) with
- a selective filter (9) which attenuates the working channel (14) more than the neighbouring channels (15₋₉ - 15₉),
- an analog/digital converter (5) which detects the filtered measurement signal in parallel broadband over all channels to be measured (15₋₉ - 15₉) and converts this into a digital signal, and
- an equaliser (11) which equalises the digital signal with a frequency response reciprocal to the frequency response of the selective filter (9).

8. A measurement device according to claim 7, **characterised in that** the selective filter (9) attenuates the measurement signal in the adjacent channels (15₋₉ - 15₉) increasingly weakly as the distance from the working channel (14) increases.

9. A measurement device according to claim 7 or 8, **characterised in that** connected before the analog/digital converter (5) is a variable amplifier (4) or a variable attenuator, the amplification factor or attenuation factor of which is set so that the modulation range of the analog/digital converter (5) is fully utilised at least almost completely without over-modulation.

10. A measurement device according to any of claims 7 to 9, **characterised in that** after the analog/digital converter (5) is connected a digital bandpass 0. filter (3).

11. A measurement device according to claim 10, **characterised in that** as well as the spectra in the neighbouring channels (15₋₉ - 15₉), the spectrum in the working channel (14) is also measured and the bandpass filter (3) for the working channel (14) has a greater bandwidth than for the adjacent channels (15₋₉ - 15₉).

12. A measurement device according to claim 10 or 11, **characterised in that** the equaliser (11) and the bandpass filter (3) are part of a digital signal processor (7).

## Revendications

1. Procédé de mesure du spectre d'un signal de mesure dans plusieurs canaux adjacents (15₉-15₉) avoisinant un canal utile (14) comprenant les étapes consistant à:
- détection parallèle, sur la largeur de la bande, du signal de mesure sur tous les canaux à mesurer (15₉-15₉, 14),
- filtrage du signal de mesure détecté sur la bande large avec un filtre sélectif (9) qui amortit le canal utile (14) plus fortement que les canaux adjacents (15₋₉-15₉),
- conversion du signal de mesure analogique filtré en un signal numérique et
- correction de la distorsion du signal numérique avec un correcteur de distorsion (11) dont la réponse harmonique est réciproque à la réponse harmonique du filtre sélectif (9) .

2. Procédé selon la revendication 1, **caractérisé en ce que** le filtre sélectif (9) amortit le signal de mesure dans les canaux adjacents (15₋₉-15₉) de moins en moins fortement au fur et à mesure qu'augmente l'écart relativement au canal utile (14).

3. Procédé selon la revendication 1 ou 2, **caractérisé en ce qu'**on mesure en même temps le spectre dans le canal utile (14).

4. Procédé selon la revendication 3, **caractérisé en ce que** le signal numérique est soumis dans le canal utile (14) à un filtrage passe-bande d'une bande plus large que dans les canaux adjacents (15₋₉-15₉).

5. Procédé selon la revendication 3 ou 4, **caractérisé en ce que** lors de la mesure du spectre du canal utile (14), le filtre sélectif (9) est mis hors service.

6. Procédé selon l'une des revendications 1 à 5, **caractérisé en ce que** le signal de mesure est un signal de radio-téléphonie mobile, en particulier un signal selon le standard GSM, EDGE ou UTMS.

7. Dispositif de mesure (1) pour mesurer le spectre d'un signal de mesure dans plusieurs canaux adjacents (15₋₉-15₉) avoisinant un canal utile (14) avec
- un filtre sélectif (9) qui amortit le canal utile (14) plus fortement que les canaux adjacents (15₋₉-15₉),
- un convertisseur analogique/numérique (5) qui détecte parallèlement, sur une bande large, le signal de mesure filtré sur tous les canaux à mesurer (15₋₉-15₉) et le convertit en un signal numérique et
- un correcteur de distorsion (11) qui corrige le signal numérique avec une réponse harmonique réciproque à la réponse harmonique du filtre sélectif (9).

8. Dispositif de mesure selon la revendication 7, **caractérisé en ce que** le filtre sélectif (9) amortit de plus en plus faiblement le signal de mesure dans les canaux adjacents (15₋₉-15₉) au fur et à mesure qu'augmente l'écart relativement au canal utile (14).

9. Dispositif de mesure selon la revendication 7 ou 8, **caractérisé en ce qu'**il est disposé en amont du convertisseur analogique/numérique (5) un amplificateur variable (4) ou un élément d'amortissement variable, dont le facteur d'amplification respectivement le facteur d'amortissement est réglé de façon que la zone d'utilisation du convertisseur analogique/numérique (5), sans surmodulation, est utilisée au moins presque entièrement.

10. Dispositif de mesure selon l'une des revendications 7 à 9, **caractérisé en ce qu'**un filtre passe-bande numérique (3) est disposé en aval du convertisseur analogique/numérique (5).

11. Dispositif de mesure selon la revendication 10, **caractérisé en ce que**, à part les spectres dans les canaux adjacents (15₋₉-15₉), également le spectre dans le canal utile (14) est mesuré, et **en ce que** le filtre passe-bande (3) présente pour le canal utile (14) une plus grande largeur de bande que pour les canaux adjacents (15₋₉-15₉).

12. Dispositif de mesure selon la revendication 10 ou 11, **caractérisé en ce que** le correcteur de distorsion (11) et le filtre passe-bande (3) font partie d'un processeur numérique des signaux (7).
